(19) Europäisches Patentamt
European Patent Office
Office européen des brevets

(11) EP 1 747 558 B1

(12) **EUROPEAN PATENT SPECIFICATION**

(45) Date of publication and mention of the grant of the patent:
**28.12.2011 Bulletin 2011/52**

(21) Application number: **05749124.3**

(22) Date of filing: **17.05.2005**

(51) Int Cl.:
***G11C 13/00*** *(2006.01)*

(86) International application number:
**PCT/US2005/016999**

(87) International publication number:
**WO 2005/117023 (08.12.2005 Gazette 2005/49)**

# (54) A COMPOSITION OF MATTER WHICH RESULTS IN ELECTRONIC SWITCHING THROUGH INTRA- OR INTER- MOLECULAR CHARGE TRANSFER BETWEEN MOLECULES AND ELECTRODES INDUCED BY AN ELECTRICAL FIELD

ZUSAMMENSETZUNG VON MATERIE, DIE ZU EINER ELEKTRONISCHEN UMSCHALTUNG DURCH INTRA- ODER INTERMOLEKULAREN LADUNGSTRANSFER ZWISCHEN MOLEKÜLEN UND ELEKTRODEN FÜHRT, DER DURCH EIN ELEKTRISCHES FELD INDUZIERT WIRD

COMPOSITION DE MATIERE QUI ENTRAINE UNE COMMUTATION ELECTRONIQUE PAR TRANSFERT DE CHARGE INTRA OU INTER MOLECULAIRE ENTRE DES MOLECULES ET DES ELECTRODES INDUIT PAR UN CHAMP ELECTRIQUE

(84) Designated Contracting States:
**AT BE BG CH CY CZ DE DK EE ES FI FR GB GR HU IE IS IT LI LT LU MC NL PL PT RO SE SI SK TR**

(30) Priority: **18.05.2004 US 848772**

(43) Date of publication of application:
**31.01.2007 Bulletin 2007/05**

(73) Proprietor: **HEWLETT-PACKARD DEVELOPMENT COMPANY, L.P.**
**Houston, TX 77070 (US)**

(72) Inventors:
- **CHEN, Yong**
  **Los Angeles, CA 90095-1597 (US)**
- **ZHANG, Xiao-An**
  **Palo Alto, CA 94304 (US)**
- **BRATKOVSKI, Alexandre, M.**
  **Palo Alto, CA 94304 (US)**
- **WILLIAMS, Stanley, R.**
  **Palo Alto, CA 94034 (US)**

(74) Representative: **Schoppe, Fritz et al**
**Schoppe, Zimmermann, Stöckeler & Zinkler**
**Patentanwälte**
**Postfach 246**
**82043 Pullach bei München (DE)**

(56) References cited:

| | |
|---|---|
| **EP-A- 1 331 671** | **WO-A-02/091476** |
| **WO-A-02/091495** | **WO-A-03/005116** |
| **US-A- 5 761 115** | **US-A- 6 128 214** |
| **US-A1- 2002 158 244** | **US-A1- 2002 167 004** |
| **US-A1- 2003 111 670** | **US-A1- 2003 169 618** |
| **US-A1- 2003 178 667** | **US-B1- 6 256 767** |

- **KORNILOVITCH P E ET AL: "BISTABLE MOLECULAR CONDUCTORS WITH A FIELD-SWITCHABLE DIPOLE GROUP" PHYSICAL REVIEW, B. CONDENSED MATTER, AMERICAN INSTITUTE OF PHYSICS. NEW YORK, US, vol. 66, no. 24, 15 December 2002 (2002-12-15), pages 245413-1, XP001184160 ISSN: 0163-1829**
- **SINHA H K ET AL: "GROUND- AND EXCITED-STATE DIPOLE MOMENTS OF SOME NITROAROMATICS: EVIDENCE FOR EXTENSIVE CHARGE TRANSFER IN TWISTED NITROBENZENE SYSTEMS" JOURNAL OF CHEMICAL PHYSICS, NEW YORK, NY, US, vol. 93, no. 10, 15 November 1990 (1990-11-15), pages 7085-7093, XP008006682 ISSN: 0021-9606**
- **MURALIDHARAN S ET AL: "CONFORMATIONAL EFFECTS ON CHARGE-TRANSFER PROPERTIES IN SELECTED 9,10-DISUBSTITUTED ANTHRACENE DERIVATIVES: GROUND- AND EXCITED-STATE DIPOLE MOMENTS" JOURNAL OF PHYSICAL CHEMISTRY, AMERICAN CHEMICAL SOCIETY, US, vol. 95, no. 22, 31 October 1991 (1991-10-31), pages 8517-8520, XP008006699 ISSN: 0022-3654**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- KRIEGER Y H: "STRUCTURAL INSTABILITY OF ONE-DIMENSIONAL SYSTEMS AS A PHYSICAL PRINCIPLE UNDERLYING THE FUNCTIONING OF MOLECULAR ELECTRONIC DEVICES" JOURNAL OF STRUCTURAL CHEMISTRY, PLENUM PRESS, NEW YORK, NY, US, vol. 40, no. 4, 1999, pages 594-619, XP008005141 ISSN: 0022-4766
- REED ET AL: "Molecular random access memory cell" AMERICAN INSTITUTE OF PHYSICS, vol. 78, no. 23, 4 June 2001 (2001-06-04), pages 3735-3737, XP002381115

## Description

TECHNICAL FIELD

The present invention is directed to molecules and molecular systems useful for electronic and optical switching, such as in switches, sensors, transistors, and the like, at the nanometer scale.

BACKGROUND ART

Previously, molecules have been integrated with devices to make molecular transistors, in which charge and electrical properties are changed when an external electric field is applied to the molecules. In these molecules, the change in the charge and electrical properties inside the molecules will disappear after the electric field is removed. Thus, it is hot possible to use such molecules or device structures to make non-volatile devices.
WO 02 091476 A1 describes a floating gate memory device which has a floating gate and an insulating layer on the floating gate. A control gate is on the insulating layer. The insulating layer is made up of a molecular matrix with ionic complexes distributed in the molecular matrix. By the application of an electric field, the ionic complexes are dissociable in the molecular matrix to change the resistivity (or conductivity) of the insulating layer. By switching between a high resistivity (low conductivity) state, where charge is retained by the floating gate, to a low resistivity (high conductivity) state, the charge stored on the floating gate can readily drained off to the gate electrode.
US 2003/0111670 A1 describes an approach for a molecular-based FET device which uses charge storing molecules between a gate and channel of a FET-type transistor.
WO 03/005116 A1 describes an electric field activated bi-stable molecular system configured within an electric field generated by a pair of electrodes for use, e.g., as electronic ink or other visual displays. The molecular system has at least one rotor portion connected to at least one stator portion, wherein the rotor portion rotates with respect to the stator portion between at least two different states upon application of the electric field, thereby inducing a band gap change in the molecular system, wherein in a first state, there is extended conjugation throughout the major portion of the molecular system, resulting in a relatively smaller band gap, and wherein in a second state, the extended conjugation is destroyed, resulting in a relatively larger band gap.
Kornilovitch P. E. et al describe in: "Bistable Molecular Conductors with a Field-Switchable Dipole Group" Physical Review, B. Condensed Matter, American Institute of Physics, New York, US, vol. 66, no. 24, 15 December 2002, pages 245413-1,a class of bistable "stator-rotor" molecules, where a stationary bridge (stator) connects the two electrodes and facilitates electron transport between them. The rotor part, which has a large dipole moment, is attached to an atom of the stator via a single σ-bond. Hydrogen bonds formed between the rotor and stator make the symmetric orientation of the dipole unstable. The rotor has two potential minima with equal energy for rotation about the sigma bond. The dipole orientation, which determines the conduction state of the molecule, can be switched by an external electric field that changes the relative energy of the two potential minima. Such bistable stator-rotor molecules could potentially be used as parts of molecular electronic devices.
WO 02/091495 A2 describes a memory cell with an active region including a molecular system and ionic complexes distributed in the molecular system. A pair of write electrodes are arranged for writing information to the memory cell. The active region is responsive to an electric field applied between the pair of write electrodes for switching between an on state and an off state. The active region has a high impedance in the off and a low impedance in the on state. A pair of read electrodes is used to detect whether the active region is in the on state or in the off state to read the information from the memory cell. Read electrodes may be made of different materials having different work functions to reduce leakage current.
US 2003/0169618 A1 describes high density memory devices that are electrically addressable permitting effective reading and writing, that provide a high memory density (e.g., $10^{15}$ bits/cm3), that provide a high degree of fault tolerance, and that are amenable to efficient chemical synthesis and chip fabrication. The devices are intrinsically latchable, defect tolerant, and support destructive or non-destructive read cycles. The device comprises a fixed electrode electrically coupled to a storage medium having a multiplicity of different and distinguishable oxidation states wherein data is stored in said oxidation states by the addition or withdrawal of one or more electrons from said storage medium via the electrically coupled electrode. The storage medium typically comprises a storage molecule that is a triple-decker sandwich heterodimer. Such dimers can provide 8 or more oxidation states and permit the storage of at least 3 bits per molecule.
US 6,128,214 A describes a molecular wire crossbar memory (MWCM) system. The MWCM comprises a two-dimensional array of a plurality of nanometer-scale devices, each device comprising a junction formed by a pair of crossed wires where one wire crosses another and at least one connector species connecting the pair of crossed wires in the junction. The connector species comprises a bi-stable molecular switch. The junction forms either a resistor or a diode or an asymmetric non-linear resistor. The junction has a state that is capable of being altered by application of a first voltage and sensed by application of a second, non-destructive voltage.

US 2002/0158244 A1 describes a method of and an apparatus for controlling an electric current through a medium, comprising the steps of applying a voltage at two electrodes being coupled to the medium at two different positions, and changing of at least one physical parameter of said medium, so as to change the conductivity of said medium. In order to improve performance of molecular electronic devices it is suggested that said medium comprises a chain molecule including a plurality of molecular sections and changing of said at least one physical parameter of the medium includes one parameter that blocks the internal movement of adjacent molecular sections of said chain molecule.

## SUMMARY OF THE INVENTION

It is the object of the present invention to provide an improved an approach for making non-volatile devices that retain the change in charge and electrical properties when the external electric field is removed.
This object is achieved by a molecular thin film according to claim 1.
Further, the invention provides a device comprising the inventive molecular thin film.

## BRIEF DESCRIPTION OF THE DRAWINGS

FIG. 1 schematically depicts an example of a conventional two-electrode memory device, comprising molecules sandwiched between two electrodes;
FIG. 2 schematically depicts an example of a conventional three-electrode device, comprising a gate, source, and drain, with the molecules between the gate and the source/drain;
FIG. 3A is a generic example of charge separation or localization under influence of an external electric field (E-field) according to an embodiment of the invention;
FIG. 3B is a specific molecular example of the generic example of FIG. 3A, depicting uni-molecular charge separation or localization under influence of the external E-field according to an embodiment of the invention;
FIG. 3C is a specific molecular example of the generic example of FIG. 3A, depicting bi-molecular charge separation or localization under influence of the external E-field according to an embodiment of the invention;
FIG. 4A is a generic example of the switching direction of the molecular dipole movement under influence of an external E-field according to an embodiment of the invention;
FIG. 4B is a specific molecular example of the generic example of FIG. 4A, depicting the switching direction of the molecular dipole movement under influence of the external E-field according to an embodiment of the invention;
FIG. 5A is a generic example of the intermolecular charge transfer and creating or erasing the molecular thin film dipole under influence of an external E-field according to an embodiment of the invention;
FIG. 5B is a specific molecular example of the generic example of FIG. 5A, depicting the intermolecular charge transfer and creating or erasing the molecular thin film dipole under influence of the external E-field according to an embodiment of the invention;
FIG. 6A is a generic example of the charge density change within molecules under influence of an external E-field according to an example ;
FIG. 6B is a specific molecular example of the generic example of FIG. 6, depicting the charge density change within molecules under influence of the external E-field according to an example ; and
FIGS. 7A and 7B depict examples of two configurations (parallel and series, respectively) for electrically connecting together a two-electrode device and a three-electrode device, employing the teachings herein, according to embodiments of the invention.

## BEST MODES FOR CARRYING OUT THE INVENTION

Reference is made now in detail to specific embodiments, which illustrates the best mode presently contemplated by the inventors for practicing the invention. Alternative embodiments are also briefly described as applicable.
In accordance with the teachings herein, a composition of matter is provided that results in electronic switching through an intra- or inter-molecular charge transfer, or through a charge transfer between a molecule and electrodes induced by electrical field. The goal is to switch a molecule/molecular complex between low- and high-conductivity states. The idea is to initiate a charge transfer to/from the molecule by applying an external electric field, resulting in the molecule acquiring an extra charge, or losing a charge, and changing its conductivity as a result. The composition of matter permits the fabrication of non-volatile devices that retain the change in charge and electrical properties when the external electric field is removed.
In memory or logic molecular devices employing molecules as the active element, a voltage (or electric field - E-field) can be applied to the molecule to induce (or eliminate or reduce) a charge transfer via intra- or inter-molecular mechanisms or between molecules and electrodes. For example, as is well known, a positive and negative charge in a molecule can be separated by a certain distance in the equilibrium position with external electrical field ($\overline{E}$) equal to zero.

As the external E-field is applied to the molecule, depending on its direction, it will either push the positive/negative charges together, which may cause the recombination of the charges and neutralize the molecule even after the external field is removed or, if the external field is applied in the opposite direction, it may reverse the process, and increase the charge dipole movement in the molecules, separating the positive and negative charges even further.

The charge transfer may also happen between neighboring molecules in the similar way as the external electrical field is applied, as is also well known. Thus, a positively-charged molecule can be separated from a negatively-charged molecule by a certain distance with the external electrical field equal to zero. As above, as the external E-field is applied to the neighboring molecules, the E-field will either push the positive/negative charges together, which may cause the recombination of the charges and neutralize the pair of molecules even after the E-field is removed, or, if the external field is applied in the opposite direction, it may reverse the process, and increase the charge dipole movement in the molecules, separating the positive and negative charges even further.

The charge transfer may also happen between electrodes and molecules where the external electrical field is applied between a pair of electrodes having a molecule sandwiched therebetween. Depending on its direction, the electric field may cancel a charge or induce a charge in the molecule, as is well known.

The charge transfer will change the charge occupancy in molecules, or the energy level of the molecule, resulting in a change of the electrical properties of the molecule, which can be used in memory/logic devices.

Two-electrode memory devices 10, depicted in FIG. 1, are known in the art and typically comprise a molecule 12 sandwiched between two electrodes 14 and 16. For such devices 10, the change of the electric properties can be detected by applying a E-field having a value less than the value of the E-field causing the charge transfer. The difference in electric properties (e.g., tunneling current) can be detected when the charge condition in the molecules 12 is different. Therefore, it is possible to determine an I/O (input/output) bit stored in the molecules 12.

Three-electrode devices 20, also known in the art, are depicted in FIG. 2 and comprise a molecule 12 sandwiched between a gate electrode 14' and an electrode 16' comprising a source 22 and drain 24, wherein the source and drain are separated by a channel region 26. For such three-electrode devices 20, the different charges in the molecule 12 can induce an electric field in the source/drain, or semiconductor, electrode 16'. The current between source 22 and drain 24 in this electrode 16' can be influenced by the E-field. Therefore, the current is determined by the charge inside the molecule 12, which in turn can be changed by the voltage applied in the gate electrode 14'. This configuration can form a transistor 20 for memory/logic applications.

A. Logic and Memory Devices Made by Molecule/Semiconductor and/or Molecule/Metal Junctions with Charge Transfer in Molecules and/or Between Molecule and Metal/Semiconductor

The molecules 12 have their HOMO/LUMO (Highest Occupied Molecular Orbital/Lowest Unoccupied Molecular Orbital) energy levels, with a Fermi energy level between them. Semiconductors also have a Fermi energy level between the conduction band and the valence band of the semiconductor. As is well known, when a layer of molecules 12 form a junction with a semiconductor/metal electrode, the Fermi levels between the molecules and semiconductor/metal equilibrate, adjusting the various energy levels. As a consequence, the molecules 12 may be oxidized/reduced (or electrons may be depleted/added to the molecules).

Specifically, consider the case prior to contacting the molecules with the electrodes in either of the foregoing devices 10, 20, in which one of the electrodes comprises a semiconductor material and the other of which comprises a metal. The semiconductor electrode is characterized by a conduction band (CB) and a valence band (VB), with a Fermi level therebetween. The Fermi level for the molecule (with a dopant) is located between the HOMO and LUMO levels, but not at the same energy level as the Fermi level for the semiconductor.

Once the molecule forms a junction with the semiconductor, the Fermi levels of the semiconductor and the molecule merge, or achieve an equilibrium state, and bending of the bands occurs, as is well known.

Generally, there are different work functions for electrons on the molecule, $q^{\Phi}{}_{m}$ and the electrode, $q^{\Phi}{}_{el}$. When the work functions are brought into contact by contacting the molecule with the electrode, there will be a charge transfer between them, and in equilibrium there will appear a charge density $\rho(x)$, and the established electrostatic potentials on both entities will be different, $\varphi_m \neq \varphi_{el}$. The condition of equilibrium is

$$q(\varphi_{el} - \varphi_m) = q\Phi_{el} - q\Phi_m ,$$

or, through the charge density one can rewrite this as

$$\int d^3x'\rho(x')\left(\frac{1}{|x_m - x'|} - \frac{1}{|x_{el} - x'|}\right) = \Phi_m - \Phi_{el},$$

where $x_m$ is the position of the molecule and $x_{cl}$ is the point in the electrically neutral region in the electrode.

For different molecules, the charge distribution within the molecule can change, say from $\rho^M{}_1(x) \Leftrightarrow \rho^M{}_2(x)$ or vice versa. However, as long as the charge distribution $\rho^M{}_1(x)$ satisfies Eqn. 1, with the charge distribution on the semiconductor/metal side changed accordingly, it will be a stable state. In other words, there are possible different bistable or multistable states existing for the same molecules, but with different charge distributions. Further, these molecules can transfer from one state to other states by charge transfer within the molecule.

One example is a molecule with a charged ring that can move around inside the molecule; well known examples of such molecules include rotaxanes and catenanes.

Another example is a molecule that has charges (electrons or ions) moving from one location to a different location.

Yet another example is a molecule that has a dipole moment that switches from one direction to another.

Still another example is a molecule that can change the charge density within the molecules.

In other words, all different states of the molecule 12 may find an equilibrium state with semiconductor/metal, and these different states may change from one state to another.

One application of the foregoing is in the two-electrode memory device 10, as shown in FIG. 1 and discussed above.

If the charge distribution within the molecule 12 can transfer from a first state (State A) to a second state (State B) by applying an electric field between electrodes 14 and 16, then the difference of molecular states can be detected with lower electric field/current, which can be used for a memory device 10.

Another application of the foregoing is in the transistor 20 for logic and memory, as shown in FIG. 2 and discussed above. If the charge distribution within the molecules 12 transfers from State A to State B, then the charge distribution within the semiconductor electrode 16' between the source 22 and drain 24 can be changed, which can turn ON/OFF the current between the source and drain. If the charge transfer can be controlled by the gate electrode 20 on top of the molecules 12, then it forms a three-terminal transistor 20.

B. Molecular Examples

The following examples are directed to a composition of matter which results in electronic switching through intra- or inter-molecular charge transfer, or charge transfer between a molecule and an electrode induced by an external electrical field.

In memory or logic molecular devices, a voltage (or electrical field) can be applied in the molecular thin film (monolayer or multi-layers) to induce (or eliminate or reduce) the charge transfer via an intra- or inter-molecules or between molecules and electrodes. For example, as shown and described for model 1 and model 2 below, a positive and negative charge can be separated at a certain distance in the equilibrium position with the external electrical field equal to zero. As an external field is applied to the molecule, it will either push the positive/negative charges together, which may cause the recombination of the charges and neutralize the molecule even the external field is removed, or, if the external field is applied in the opposite direction, it may reverse the process and increase the charge dipole movement in the molecule.

The charge transfer may also take place between neighboring molecules in a similar way as described above as an electrical field is applied, as shown and described for model 3 below.

The charge transfer may also take place between electrodes and molecules. As an electrical field is applied between two electrodes, it may inject a charge into the molecule or it extract a charge from the molecule, as shown and described for model 4 below.

The charge transfer changes the charge occupancy in the molecule, or the energy level of the molecule, resulting in a change of the electrical properties of the molecule that can be used in memory/logic devices.

FIGS. 3A, 4A, 5A, and 6A show several generic models (models 1-4) of switching molecules in which their molecular band gaps, dipoles, or charge distribution change under the influence of an applied external E-field. FIGS. 3B, 3C, 4B, 5B, and 6B illustrate specific examples of explaining how these generic models work.

Model 1: E-Field Induced Band Gap Change Caused by Charge Separation or Localization (or Recombination) Accompanied by Increasing or Decreasing Band Localization:

FIG. 3A is a schematic depiction of this model, which involves an E-field-induced band gap change caused by charge separation or recombination (or localization) accompanied by increasing or decreasing band localization. FIGS. 3B and 3C are two specific molecular examples of how this model works. It is worth noting that all of the specific examples described below use ion pairs as the preferred molecular state to start with. However, other types of charge pairs or hidden charge pairs are possible even though they are not explicitly described here. All of the examples are only illustrative

of the preferred embodiment, and are not intended to be limiting.

As shown in FIG. 3A, the molecule 112 comprises three units, or moieties: A, B, and C. Portion A comprises a moiety containing both positive and negative charges. The molecule 112, as formed (FIG. 3A-1), evidences a larger band gap state, with less π-delocalization. Application of an electric field causes charge separation in the molecule 112 (FIG. 3A-2), resulting in a smaller band gap state, with better π-delocalization. Recombination (or relocalization) of the charges returns the molecule to its original state (FIG. 3A-1).

The following requirements must be met in this model:

(1) Units A, B, and C must be conjugated moieties with at least one π-bond within each moiety.

(2) Unit C links both units A and B together to form a completed conjugated molecular system from A to B.

(3) One of the units preferably has a localized charge pair (or ion pair) or hidden charge pair within the moiety.

(4) The molecule 112 is electronically neutral with or without a localized charge pair without an applied external E-field.

(5) However, the charge pairs will be separated or recombined (delocalized or localized) under the influence of applied external E-field by aligning themselves with the direction of applied external E-field.

(6) Units A, B, and C can be the same or different in unit-molecular structure. Units A, B and C can be, but are not limited to, any one of the following: unsaturated hydrocarbons or substituted hydrocarbons, heterocyclic systems, or derivatives thereof.

FIGS. 3B and 3C depict two specific examples of how the charge separation or localization occurs under the influence of the applied external E-field.

It is worth noting that the charge pair (or ion pair) can result from a single molecule or bi-molecules, depending on the application. FIG. 3B is a specific example of the charge pair (or ion pair), employing a single molecule, while FIG. 3C below is a specific example of the ion pair, employing a bi-molecule.

In the specific example depicted in FIG. 3B, the molecule 112 comprises three parts or units: A, B and C. The molecule is electronically neutral with a localized charge pair without applied external E-field (FIG. 3B-1). There is a uni-molecular ion pair that resides within the unit A in its original state. However, the charges (or the uneven electron distribution) of the molecule are highly mobile due to those extremely mobile p- and π-electron clouds in this completed conjugated molecular system. When an external E-field is applied to the molecule 10 (FIG. 3B-2), the charge density of the molecule starts to redistribute, and the charge pair will be separated or recombined (delocalized or localized) accordingly under the influence of applied external E-field by aligning with the direction of the applied external E-field.

The molecule 112 as depicted in FIG. 3B-1 evidences a larger band gap and smaller molecular dipole state, due to the localized charge pair. Application of an electric field causes the positive charge relocation from unit A to B through the highly mobile π-system in the molecule 112, resulting in a smaller band gap and larger molecular dipole state as depicted in FIG. 3B-2, due to a maximized charge separation. Reversal of the E-field will move the positive charge toward the negative charge region and returns the molecule 112 to its original state (FIG. 3B-1).

In FIG. 3B, units A, B, and C here are three conjugated units. Unit A is an N-substituted pyridine ring with a charge pair residing within the ring and unit B is a N,N-di-substituted aniline ring. Unit C is a linear conjugated chain linking both units A and B together to form a completed conjugated molecular system from A through C to B.

It is worth pointing out that the A and B units do not have to be a substituted pyridine ring or an aniline ring, respectively. The A and B units can be any substituted aromatic hydrocarbon or heterocycle system (such as substituted indole, substituted naphthalene, anthracene, etc.).

Z1, Z2, Z3, Z4, Z5, and Z6 can be the same or different subunits. They can be a simple hydrocarbon subunit (e.g., -CH=, -CR=, or -C=, etc.) or a heteroatom atomic group (e.g., -N=, or -P=, etc.).

$R_1$ and $R_2$ can be the same or different and they can be a hydrogen atom, an alkyl, an aryl group or a substituted hydrocarbon.

In FIG. 3C, the molecule is made up of three parts: units A, B, and C. There is a bi-molecular ion pair (charge pair) resides near the region of unit A resulting from a $C10_4^-$ anion and N-alkylated cation in its original state. However, the positive charge within the region of unit A of the molecule 112 can be easily moved to different regions of the molecule (B or C) under the influence of applied external E-field through the highly mobile conjugated π-electron system within the molecule. As a result, the charge pair will be separated or recombined (delocalized or localized) via the p-, π-electron density redistribution under the influence of applied external E-field by aligning themselves with the direction of applied external E-field. The molecule evidences a smaller molecular dipole state in FIG. 3C-1 due to the localized charge pair. Application of an electric field causes the positive charge migration from unit A to B through the highly mobile π-system in the molecule, resulting in a larger molecular dipole state in FIG. 3C-2 due to a maximized charge separation. Reversal of the E-field will move the positive charge toward the negative charge region and returns the molecule 112 to its original state (FIG. 3C-1).

It is worth pointing out that the units A, B, and C do not have to be as described above. They can be any substituted aromatic hydrocarbon or heterocycle system (such as substituted indole, substituted naphthalene, anthracene, etc.).

Model 2: E-Field Induced Molecular Dipole Switching Caused by the Change of Extended Conjugation Via Charge Separation, Migration Or Recombination with or without π-Bond Breaking or Formation:

FIG. 4A is a schematic depiction of this model, which involves an E-field-induced band gap change and molecular dipole switching caused by the change of extended conjugation via charges separation, migration or recombination, with or without π-bond breaking or formation. FIG. 4B is a specific molecular example of how this model works. It is worth noting that this specific example described below use charge pair as the preferred molecular state to start with. However, other types of hidden charge pairs are possible even though they are not explicitly described here. The example is only illustrative of the preferred embodiment, and is not intended to be limiting.

As shown in FIG. 4A, the molecule 212 comprises three portions A, B, and C. The molecule in FIG. 4A-1 evidences a larger band gap state due to charge localization and/or charge combination and a σ-bond formation in the central portion of the molecule (unit C). Application of an electric field (FIG. 4A-2) causes a charge separation within the molecule 212, and the molecule is highly polarized with the induced dipole 240 aligning with the applied external E-field with or without a breaking of the σ-bond in the middle molecule, resulting in a smaller band gap state. Reversal of the E-field (FIG. 4A-3) will switch the induced molecular dipole 240 and cause it to change to the opposite direction. Upon removal of external E-field (FIG. 4A-1'), the induced opposite charges will migrate toward each other through highly mobilized π-chains and co-reside or charge recombine to form a σ-bond in the middle portion of molecule 212 and return the molecule to its original larger band gap state.

The following requirements must be met in this model:

(1) The molecule must have a modest dielectric constant ($\varepsilon > 3$) and be polarized by an external E-field.

(2) At least one segment of the molecule must have π- and p-electrons that can be mobilized over the entire molecule or a part of the molecule.

(3) The molecule 212 can be symmetrical or asymmetrical.

(4) The inducible dipole(s) 240 of the molecule 212 can be oriented in at least one direction.

(5) The charges may be separated either partially or completely during E-field induced polarization.

(6) The states of charge separation or recombination can be E-field dependent or bi-stable, stabilized through inter- or intra-molecular forces such as covalent bond formation, hydrogen bonding, charges attraction, coulomb forces, metal complexes, or Lewis acid (base) complexes, etc.

(7) The process of charge separation of the molecule 212 can involve or not involve σ- and π-bond breakage or formation.

(8) During the charge separation or re-combination process activated by an E-field, the band gap of the molecule 212 will change, depending on the degree of the p- and π-electron de-localization in the molecule. Both optical and electrical properties of the molecule 212 will be changed accordingly.

FIG. 4B is a specific example of how the applied external E-field induces band gap change caused by the change of extended conjugation via charge separation or recombination and π-bond breaking or formation.

As shown in FIG. 4B-1, the molecule 212 comprises three portions, or units, A, B, and C. The molecule 212 evidences a larger band gap state due to the breakage of conjugated p-chains between two ending portion of the molecule (units A and B), and a σ-bond formation in the central portion of the molecule (unit C). Application of an electric field causes a breaking of the σ-bond in the middle molecule, thereby re-establishing a complete π-communication through the entire upper portion of the molecule 212 (from A to B).

Charge separation through the newly established highly delocalized π-system within the upper portion of the molecule 212 results in a smaller band gap state. In this state, the molecule is highly polarized with the induced dipole 240 to align it with the direction of the applied external E-field (FIG. 4B-2). Reversal of the E-field (FIG. 4B-3) will switch the induced molecular dipole 240 to the opposite direction. Upon removal of external E-field, the induced opposite charges will migrate toward each other through highly mobilized π-chains and co-reside or charge recombine to form a σ-bond in the middle portion (C) of the molecule 212 and return the molecule to its original larger band gap state (FIG. 4B-1).

A modified rhodamine-lactone type of molecules is shown in FIG. 4B, in which the C-O bond of the lactone is sufficiently labile enough and can undergo a bond breaking and forming (see the example described in FIG. 4B) under the influence of an applied electric field. However, other bond breaking and forming mechanisms may alternatively be employed.

A positive and a negative charge are generated during the C-O bond breaking process. The resulting charges will be separated and move in opposite directions parallel to the applied external field (upper part of the molecule 212), or bond rotation (lower part of the molecule), as illustrated in FIG. 4B-2. The top portion of the aromatic system with an extended dipole 240 (upper part and lower part) of the molecule 212 is completely conjugated.

When a reverse E-field is applied, as shown in FIG. 4B-3, both charges tend to realign themselves to the direction of the reverse external field. The positive charge on the upper part of the molecule 212 will migrate to another end of the top portion of the molecule through the π-electron system. Likewise, the negative charged lower part of the molecule 212 will tend to move closer to the external E-field through C-C bond rotation. A feature of the molecule design

is that there is at least one strong electron withdrawing group (W) on the aromatic ring in the lower portion of the middle part of the molecule (unit C) that will make the C-O bond of the lactone sufficiently labile enough that it can undergo a bond breaking and forming (as described above) under the influence of an applied electric field or removal of the E-field. When the external E-field is removed, the positive charge in the upper portion of the molecule 212 will migrate toward the center of the molecule through highly mobilized $\pi$-chains and the negative charged sector in the lower part of the molecule will rotate about 90 degree towards the center. Furthermore, this 90-degree orientation is stabilized by a C-O bond formation and charge recombination. During this process, a tetrahedral carbon (an isolator) is formed at the tri-aryl methane position. The conjugation of the molecule is broken and the HOMO and LUMO are no longer delocalized over the entire upper part of the molecule 212. This has the effect of shrinking the size of the volume occupied by the electrons, which causes the HOMO-LUMO gap to increase.

The letter W is an electron-withdrawing group. The function of this group is to tune the reactivity of the lactone group of this molecule, which enables the molecule to undergo a smooth charge separation or recombination (bond breaking or formation, etc.) under the influence of an applied external E-field. The electron-withdrawing group may be any one of the following: carboxylic acid or its derivatives (e.g., ester or amide, etc.), nitro, nitrile, ketone, aldehyde, sulfone, sulfuric acid or its derivatives, hetero atoms (e.g., F, Cl, etc.) or a functional group with at least one hetero atom (e.g., F, Cl, Br, N, O, S, etc.), hydrocarbon (either saturated or unsaturated) or substituted hydrocarbon.

The letters $Z_1$, $Z_2$, and $Z_3$ are used here to designate connecting units between two phenyl rings. It can be any one of following: S, O, NH, NR, hydrocarbon, or substituted hydrocarbon.

The letters $Z_4$, $Z_5$, $Z_6$, and $Z_7$ are connecting groups between aromatic portions of the molecule. They may be any one of the following: hetero atoms (i.e., N, O, S, P, etc.) or functional groups with at least one of above-mentioned hetero atoms (e.g., NH, PH, etc.), hydrocarbon (either saturated or unsaturated) or substituted hydrocarbon.

The letters $R_1$, $R_2$. $R_3$, and $R_4$ represent ending groups or linking groups built into the molecule. The function of these groups is to protect the nitrogen atom with appropriate atom (or group) and allow the molecule to connect to a solid substrate or an electrode during the chemical assembly process. They may be any one of the following: hydrogen, hydrocarbon (either saturated or unsaturated) or substituted hydrocarbon.

Model 3: E-Field Induced Bi-Molecular Charge-Complex Creation and Charge Separation Via an Intermolecular Charge Transfer:

FIG. 5A is a schematic depiction of this model, which involves an E-field-induced inter-molecular charge transfer and dipole creation via charge-complex creation and separation, while FIG. 5B is a specific molecular example of how this model works. It is worth noting that this specific example, described below, uses bi-molecular charge transfer through adjacent molecules as the preferred example to start with. However, other types of charge transfer involving more than two adjacent molecules are possible even though they are not explicitly described here. The example is only illustrative of the preferred embodiment, and is not intended to be limiting.

As shown in FIG. 5A, the organic solid thin film 312, shown in FIG. 5A-1, is formed by the combination of two (or more) types of neutral molecules (A and D or plus other(s)). One of the moieties is an electron donor (D) (i.e., has a low ionization potential and can be easily oxidized; < 10.9 eV) and the other is an electron acceptor (A) (i.e., has a high electron affinity and can be easily reduced; > 0.46 eV). This organic solid thin film (FIG. 5A-1) is an electrical insulator with room temperature conductivity values, $\sigma_{rt} \leq 10^{-12}$ $Scm^{-1}$ due to no direct charge transfer between the donor and acceptor molecules without the influence of the external E-field.

However, when an external E-field is applied to the thin film 312 (FIGS. 5A-2, 5A-3), an electron is transferred from the donor molecule (D) to the acceptor molecule (A) (as shown in FIG. 5A-3), under the influence of particular direction of the applied external E-field. This leaves behind an organic radical cation that has a "free" electron, that is, an electron that is not strongly involved in the bonding. The corollary is that the acceptor molecule (A) will have gained an electron to become an anion radical. A radical charge pair results from the E-field induced charge transfer between donor and acceptor molecules with a local E-field built in the organic solid thin film 312. This enhances the electronic conductivity of the organic solid thin film 312 (FIG. 5A-3) greatly. As is well known, a radical cation is usually generated through inter-molecular electron transfer, while a cation is generated by an inter- or intra-molecular charged atom or atomic group transfer (i.e., $H^+$). A radical anion is analogously generated.

Upon reversal of the applied external E-field, a reverse charge transfer is facilitated (FIG. 5A-2). The donor molecule (D) has a low ionization potential, so its corresponding radical cation can only recover one electron to become a neutral molecule during the reversal process of switching external E-field (as shown in FIG. 5A-2), and it cannot receive more than one electron to become radical anion. The corollary is that the radical anion of the acceptor molecule (A) will only give up one electron to become neutral molecule and cannot lose more than one electron to become a radical cation due to its high electron affinity properties. As a result, the organic thin film 312 returns back to its original no-charge state and insulating state (FIG. 5A-2). This type of E-field induced charge transfer property can be used as either a two-terminal or three-terminal molecular switch, for example.

The following requirements must be met in this model:

(1) The organic solid thin film must comprise at least two types of neutral molecules.

(2) One of the neutral molecules must be an electron donor (D) with a low ionization potential and be easily oxidized.

(3) The other neutral molecule must be an electron acceptor (A) with a high electron affinity and be easily reduced.

(4) Both donor and acceptor molecules must be chemically stable toward each other under no influence of an external E-field.

(5) The electron donor molecule can lose one or more electrons to become a radical cation or cation under the influence of an applied forward external E-field.

(6) The radical cation or cation generated from its corresponding donor molecule can only regain its missing electron(s) to become a neutral molecule under a reversal of the external E-field.

(7) The neutral donor molecule here cannot receive any electrons from a neutral acceptor molecule to become a radical anion or anion, whether in the presence or the absence of the external E-field.

(8) The electron acceptor molecule can gain one or more electrons to become a radical anion or anion under the influence of an applied forward external E-field.

(9) The radical anion or anion resulted from its corresponding acceptor molecule can only give up its excess electron(s) to become a neutral molecule under a reversal of the external E-field.

(10) The neutral acceptor molecule here cannot lose any electrons to the donor molecule to become a radical cation or cation, whether in the presence or the absence of the external E-field.

(11) Both donor and acceptor molecules can be packed close together or separated in distance in the solid thin film.

(12) In the case where the donor and acceptor are separated in distance, at least one electronically neutral molecule can be employed in between the donor and acceptor in the solid thin film.

(13) Spacing between the donor and acceptor is preferred to ensure the bi-stability of charge transfer complex from the donor and acceptor molecules.

FIG. 5B is a specific example of how the applied external E-field induces intermolecular charge transfer between two adjacent molecules (donor and acceptor).

As shown in FIG. 5B, the molecule 312 comprises two portions, labeled Acceptor and Donor. The acceptor molecule depicted is a 7,7,8,8-tetra-substituted quinodimethane derivative with a high electron affinity, and the donor molecule depicted is a tetra-substituted fulvalene derivative with a low ionization potential.

$R_{1,}$ $R_2$, $R_3$, and $R_4$ may be the same or different and are selected from the group consisting of a hydrogen atom, an alkyl group, an aryl group, a substituted hydrocarbon with at least one hetero atom in it (e.g., -O-alkyl, -O-aryl, -NH-alkyl, -NH-aryl, -S-alkyl, -S-aryl, etc.), or substituted hydrocarbon with some terminal functional groups (e.g., -COOH, -OH, $-NH_2$, -SH, -S-CO-alkyl, -S-S-alkyl, -pyridine, etc.) which are suitable for SAM (self-assembled monolayer) or LB (Langmuir-Blodgett) thin film preparation. Preferably, $R_1$, $R_2$. $R_3$, and $R_4$ groups are substituted alkyl chains so as to provide sufficient spacing between the donor and the acceptor portions to improve the bi-stability of the molecular thin film in both the charge transferred state and the non-charge transferred state. In other words, there will be no forward or backward charge transfer between the donor and acceptor molecules in their solid thin film if no external E-field is applied to it. The charge transfer will only proceed under the influence of an applied external E-field. Under the influence of an applied forward external E-field, an electron is transferred from the donor to the acceptor molecules by tunneling through the space between the two to result in a charge complex of the radical cation and radical anion (as shown in FIG. 5B-3). The organic thin film 312 becomes much more conductive in this state. When a reversed external E-field is applied, the backward charge transfer from the radical anion to the radical cation results in two types of neutral molecules in the thin film, as shown in FIG. 5B-2. This leads a highly electronically insulating state.

In the donor molecule, $Y_1$ and $Y_2$ may be the same heteroatom or different. They can be any one of the following: S, O, Se, NH, N-alkyl, N-aryl, P-alkyl, P-aryl, etc.

In the acceptor molecule, $X_1$, $X_2$, $X_3$, and $X_4$ may be the same functional group or different. They can be a hydrogen atom, an alkyl group, an aryl group, a substituted hydrocarbon with at least one hetero atom in it (e.g., -O-alkyl, -O-aryl, -NH-alkyl, -NH-aryl, -S-alkyl, -S-aryl, -Se-alkyl, -Se-aryl, etc.), or substituted hydrocarbon with some terminal functional groups (e.g., -COOH, -OH, $-NH_2$, -SH, -S-CO-alkyl, -S-S-alkyl, -pyridine, etc.).

Model 4: E-Field Induced Charge Density Change within the Molecule Via an Oxidation-Reduction (Redox) Mechanism:

The general idea is to create a thin film structure 412 that contains (a) a layer of a material that can easily be oxidized ("OX"), (b) a solid or highly viscous electrolyte, and (c) an optional layer of a material that can be easily reduced ("RED"). In the process of the oxidation or reduction, either or both materials (a) and (c) should undergo a large band gap change accompanied by charge density change. This three-layer system 412 is sandwiched between two electrodes 14, 16. Under the influence of an applied electric potential, electrons will be removed from the easily oxidized material and transferred through external circuitry to the material that can be reduced. Since at least one of these materials undergoes a large band gap change along with its charge density change, this will result in switching to the electrically

conductive state of the device. But both the oxidized and reduced materials can be reconverted back to their original redox state (or color state) under a reversed applied electric potential.

FIG. 6A is a schematic depiction of this model, which involves an E-field-induced charge density change of the molecular system via electrochemical redox reaction, while FIGS. 6B and 6C are two specific molecular examples of how this model works. It is worth noting that these specific examples described below use a substituted phthalocyanine and a substituted tetrazine as the preferred examples to start with. However, other types of redox type of molecules are possible even though they are not explicitly discussed here.

As shown in FIG. 6A, the organic solid thin film 412 is formed by the combination of two (or more) layers of neutral molecules (OX and RED or plus other(s)) along with a layer of solid or viscous electrolyte in between, as shown in FIG. 6A-1. One of the layers is an oxidizable material (OX) with a low ionization potential and the other is an easily reducible molecular material (RED) with a high electron affinity. The device is constructed by sandwiching the three-layer organic thin film 412 between two electrodes 14, 16. Under the influence of an applied increasing forward electric potential, one or more electrons will be removed from the easily oxidized material (OX) and transferred through external circuitry to the material (RED) that can be reduced (as shown in FIGS. 6A-2 and 6A-3). As a result, various charge densities and local E-fields are built into the solid thin film along with the band gap change of the molecular material(s). The oxidation states of oxidizable material can be set by a voltage difference. A particular charge state of the molecule depends on the applied voltage that sets a voltage difference between the molecule and an electrode, oxidizing or reducing it. The minimum voltage difference should be given by the energy needed to ionize or reduce the molecule. Some or all of the changes in their molecular properties under the influence of the external potential can be used to build logic and memory devices. But both the oxidized and reduced materials can be reconverted back to their original redox state (or color state) under a reversed applied electric potential.

The following requirements must be met in this model:

(1) The device must be made of a solid device medium 412 being sandwiched between two electrodes 14, 16.

(2) The solid device medium 412 must be electrically coupled to the electrode(s) 14, 16 by a number of conventional methods including, but not limited to, covalent linkage (direct or indirect through a linker), ionic linkage or physical bonding (e.g., hydrogen bonding, van der Waals force, etc.). Thus, the electron(s) can be moved from device medium to electrode or from electrode to the device medium under the influence of the external potential.

(3) The solid device medium 412 must have at least one layer of easily oxidizable molecular material (OX) with a low ionization potential (<10.9 eV).

(4) The oxidizable molecular material can be purely organic, inorganic, or organometallic or a combination of any two or more of the foregoing.

(5) The oxidizable molecular material can be a monolayer molecule or multi-layers of molecules.

(6) The easily oxidizable molecular material must have at least one distinguishable oxidation state apart from its (or their) neutral state, and can easily lose one or more electrons under the influence of an external potential.

(7) The preferred easily oxidizable molecular material should have two or more different and distinguishable oxidation states.

(8) The layer of oxidizable molecular material must be adjacent one of the electrodes 14, 16.

(9) The solid device medium 412 must have a layer of electrolyte adjacent the oxidizable molecular material.

(10) The layer of electrolyte can be a solid or viscous material.

(11) The layer of electrolyte can be one or more dielectric material(s) with or without counterions imbedded (e.g., Nafion® fluoropolymer, which is a polymer of a perfluorinated ion-exchange powder, 5 wt% solution in a mixture of lower aliphatic alcohol and water, available from Alfa (Ward Hill, MA).

(12) An optional layer of easily reducible molecular material (RED) can be used in the device material.

(13) The easily reducible molecular material must have a high electron affinity (> 0.46 eV).

(14) The easily reducible molecular material must have at least one distinguishable oxidation state apart from its (or their) neutral or original oxidation state, and can easily acquire one or more electrons under the influence of an external potential.

(15) The easily reducible molecular material can an organic, inorganic (e.g., metal, metal ion, metal oxide, or metal halide, etc.), or or ganometallic, or a combination of any two or more of the foregoing.

(16) In the case of the electrolyte containing counterions, the optional layer of reducible molecular material can be eliminated.

(17) The two electrodes 14, 16 used in the device can comprise the same or different material(s).

(18) The electrode materials can be any electrically conductive or semi-conductive material, which includes pure metals, metal alloys, metal oxides, organic conductors, etc.

FIG. 6B is a specific example of an E-field induced charge density change within the molecule via a redox mechanism

As shown in FIG. 6B, the molecule shown in FIG. 6B-1 comprises four portions: a layer of substituted metal phthalocyanine, a solid electrolyte with counterions imbedded within, and two working electrodes 14, 16. The phthalocyanine and solid electrolyte together comprise the solid device medium 412. Initially, the metal phthalocyanine has an overall zero (0) oxidation state, as shown in FIG. 6B-1, and becomes plus one (+1) or plus two (+2) state(s) with the influence of a forward external potential (as shown in FIG. 6B-2). These two oxidation states of metal phthalocyanine can be converted forward and back under a forward (FIG. 6B-2) or a reversed (FIG. 6B-1) applied electric potential.

$R_1$, $R_2$, $R_3$, $R_4$, $R_5$, $R_6$, $R_7$, and $R_8$ may be the same or different, and are selected from the group consisting of a hydrogen atom, an alkyl group, an aryl group, a substituted hydrocarbon with at least one hetero atom in it (e.g., -O-alkyl, -O-aryl, -NH-alkyl, -NH-aryl, -S-alkyl, -S-aryl, etc.), or substituted hydrocarbon with some terminal functional groups (e.g., -COOH, -OH, $-NH_2$, -SH, -S-CO-alkyl, -S-S-alkyl, -pyridine, etc.) which are suitable for SAM or LB thin film preparation.

$M^{2+}$ represents a metal ion, and may be, but not limited to, one of the following: $Be^{2+}$, $Mg^{2+}$, $Ca^{2+}$, $Sr^{2+}$, $Ba^{2+}$, $Mn^{2+}$, $Fe^{2+}$, $C^{2+}$, $Ni^{2+}$, and $C^{2+}$, etc.

The following reaction sequence provides another specific example of the E-field induced charge density change within the molecule via a redox mechanism.

As shown in the reaction sequence below, the solid device material comprises a layer of oxidizable tetrazine (Formula I) and a layer of reducible quinone (II). The tetrazine molecule (I) is oxidized to its corresponding oxidized state (I') along with the quinone being reduced under various forward external potential(s), changing color from blue (II) to magenta (II') to clear (II"). The oxidized tetrazine (I') again can be reconverted back to its original oxidation state(s) under a reversed applied electric potential, along with returning the color of the quinone to its original state.

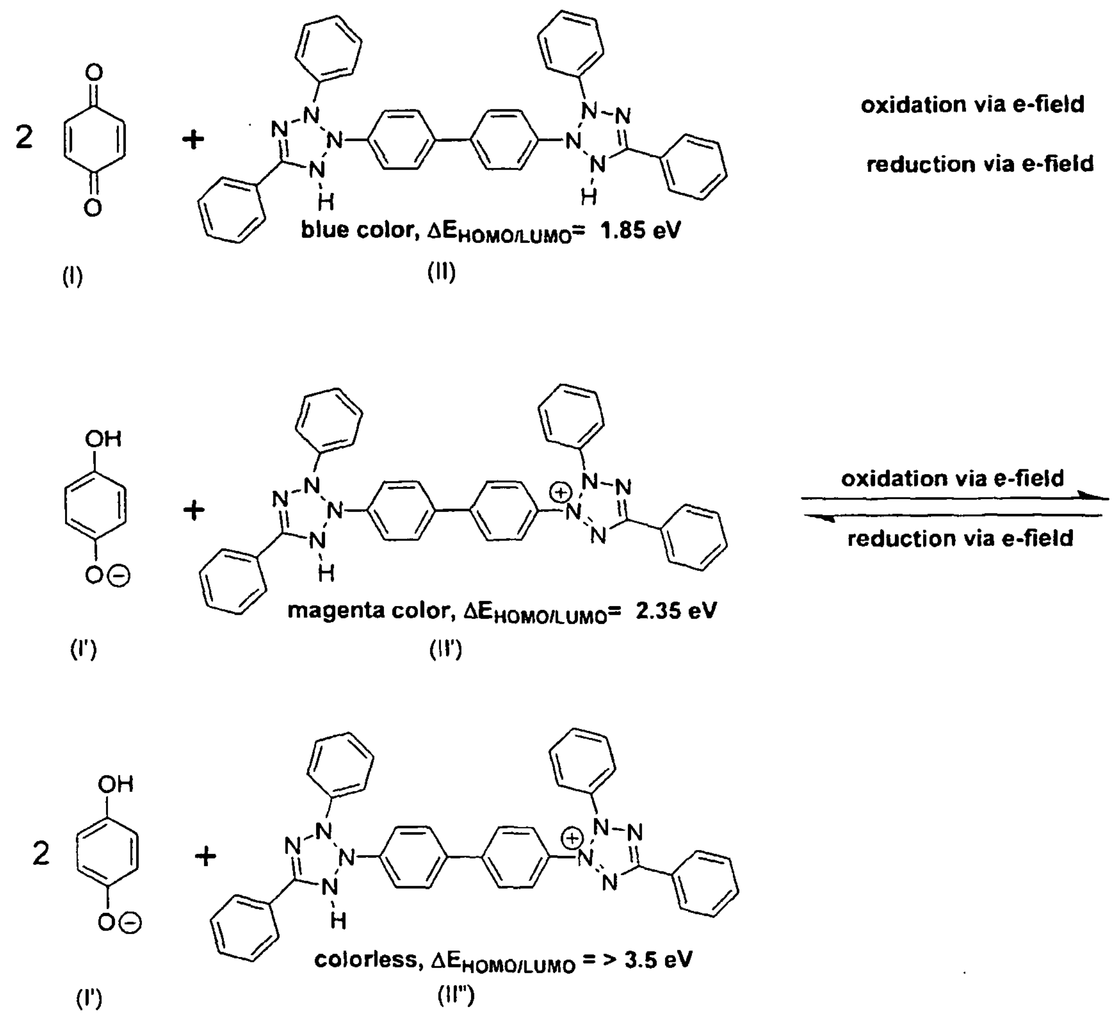


2 (I) + (II) blue color, $\Delta E_{HOMO/LUMO}$= 1.85 eV

(I') + (II') magenta color, $\Delta E_{HOMO/LUMO}$= 2.35 eV

2 (I') + (II") colorless, $\Delta E_{HOMO/LUMO}$ = > 3.5 eV

For a memory device comprising two electrodes, the change of the electric properties of the molecular thin film can be detected by applying an E-field less than the field causing the charge transfer. The difference in its electric properties (e.g., tunneling current etc.) can be detected when the charge condition in the molecular thin film is different.

Therefore, this permits determining an input/output (I/O) bit stored in the molecule.

For a three-electrode devices, the change of charge status inside molecules will influence electric properties in the semiconductor channel between source and drain. Therefore, the molecules can be used to configure the electric properties of transistor (e.g., turn on voltages, etc) for memory and logic applications.

The two-electrode device and the three-electrode device may be electrically connected together. FIG. 7A depicts a parallel connection, while FIG. 7B depicts a series connection. Various combinations of parallel and/or series connections may be made to connect the two- and three-electrode devices.

The composition of matter disclosed herein may be used in a variety of applications, including, but not limited to, molecular crossbar memories, such as disclosed in U.S. Patent 6,128,214, issued October 3, 2000; demultiplexers for molecular crossbar networks, such as disclosed in U.S. Patent 6,256,767, issued July 3, 2001; and molecular logic circuits, such as disclosed in US 2006/0102959 A1.

INDUSTRIAL APPLICABILITY

The active material disclosed herein is expected to find use in a variety of electronic and optical devices, including, but not limited to, applications involving switching, memory, logic, displays, and the like.

## Claims

1. A molecular thin film, wherein the electrical properties of molecules of the molecular thin film (112; 212) can be changed by a charge transfer within the molecular thin film (112; 212) induced by an electrical field and are retained with the electrical field removed, the molecules of the molecular thin film (112; 212) comprising:

    at least three portions (A, B, C), wherein one portion (A; C) of the at least three portions (A, B, C) comprises a charge pair that is adapted to be separated into different portions (A, B) under the influence of the electrical field, wherein the at least three portions (A, B, C) are conjugated moieties with at least one π-boned within each moiety, one moiety (C) linking the other moieties (A, B) together to form a completed conjugated molecular thin film (112), and the separated charge pair causing a large band gap when an electric field is not applied, and, or wherein conjugated p-chains between two ending portion (A, B) are broken and a σ-bond is formed in the central portion (C), when applying said electrical field
    thereby re-establishing a complete π-communication through the at least three portions (A, B, C), and the separated charge pair causing a small band gap.

2. The molecular thin film of claim 1, wherein the at least three portions comprise a plurality of neutral molecules (A, D), wherein one of the molecules (D) is an electron donor having a low ionization potential, wherein another of the molecules (A) is an electron acceptor having a high electron affinity, and wherein the charge transfer between the electron donor (D) and the electron acceptor (A) is caused under the influence of said electrical field, thereby forming a radical charge pair.

3. A device having at least two electrodes (14, 16; 14', 16') and an active material (12) electrically associated with said at least two electrodes, said active material comprising said molecular thin film of Claim 1 or 2.

4. The device of Claim 3, wherein said device (10) is a two-electrode device, comprising two electrodes(14, 16) and said active material (12) disposed therebetween and electrically associated therewith.

5. The device of Claim 4, wherein either:

    (a) both said electrodes (14,16) comprise a metal, which may be the same or different;
    (b) one of said electrodes (14,16) comprises a metal and the other of said electrodes(16, 14) comprises a semiconductor, or
    (c) both said electrodes (14,16) comprise a semiconductor, which may be the same or different.

6. The device of Claim 3, wherein said device (20) is a three-electrode device, comprising a gate electrode (14'), a semiconductor electrode (16') comprising source (22) and drain (24) regions separated by a channel region (26), and said active material (12) disposed between the gate electrode (14') and the semiconductor electrode (16'), wherein the electrical properties of said channel (26) are capable of being changed through said charge transfer in said active material(12).

7. The device of Claim 6, wherein either.

(a) said gate electrode(14') comprises a metal; or
(b) said gate electrode (14') comprises a semiconductor.

8. A device, comprising:

at least one first device (10) according to claim 4 or 5; and
at least one second device (20) according to claim 6 or 7.

9. The device of Claim 8, wherein the at least one first device (10) and the at least one second device (20) are either:

(a) connected in series; or
(b) connected in parallel.

**Patentansprüche**

1. Ein molekularer Dünnfilm, bei dem die elektrischen Eigenschaften von Molekülen des molekularen Dünnfilms (112; 212) durch eine Ladungsübertragung innerhalb des molekularen Dünnfilms (112; 212), die durch ein elektrisches Feld bewirkt wird, verändert werden können und beibehalten werden, wenn das elektrische Feld beseitigt wird, wobei die Moleküle des molekularen Dünnfilms (112; 212) folgende Merkmale aufweisen:

zumindest drei Abschnitte (A, B, C), wobei ein Abschnitt (A; C) der zumindest drei Abschnitte (A, B, C) ein Ladungspaar aufweist, das dazu angepasst ist, unter dem Einfluss des elektrischen Feldes in verschiedene Abschnitte (A, B) getrennt zu werden,
wobei die zumindest drei Abschnitte (A, B, C) konjugierte Anteile mit zumindest einer $\pi$-Bindung in jedem Anteil ist, wobei ein Anteil (C) die anderen Anteile (A, B) miteinander verbindet, um einen abgeschlossenen konjugierten molekularen Dünnfilm (112) zu bilden, und wobei das getrennte Ladungspaar einen großen Bandabstand bewirkt, wenn kein elektrisches Feld angelegt wird, und, oder
wenn konjugierte p-Ketten zwischen zwei Endabschnitten (A, B) gebrochen werden und in dem mittleren Abschnitt (C) eine $\sigma$-Bindung gebildet wird, wenn das elektrische Feld angelegt wird, wodurch eine vollständige $\pi$-Kommunikation durch die zumindest drei Abschnitte (A, B, C) wiederhergestellt wird und das getrennte Ladungspaar einen kleinen Bandabstand bewirkt.

2. Der molekulare Dünnfilm gemäß Anspruch 1, bei dem die zumindest drei Abschnitte eine Mehrzahl neutraler Moleküle (A, D) aufweisen, bei dem eines der Moleküle (D) ein Elektronendonator ist, der ein niedriges Ionisierungspotential aufweist, bei dem ein anderes der Moleküle (A) ein Elektronenakzeptor ist, der eine hohe Elektronenaffinität aufweist, und bei dem die Ladungsübertragung zwischen dem Elektronendonator (D) und dem Elektronenakzeptor (A) unter dem Einfluss des elektrischen Feldes bewirkt wird, wodurch ein Radikalladungspaar gebildet wird.

3. Eine Vorrichtung, die zumindest zwei Elektroden (14, 16; 14', 16') und ein aktives Material (12), das den zumindest zwei Elektroden elektrisch zugeordnet ist, aufweist, wobei das aktive Material den molekularen Dünnfilm gemäß Anspruch 1 oder 2 aufweist.

4. Die Vorrichtung gemäß Anspruch 3, wobei die Vorrichtung (10) eine Zweielektrodenvorrichtung ist, die zwei Elektroden (14, 16) und das aktive Material (12) aufweist, das zwischen denselben angeordnet und denselben elektrisch zugeordnet ist.

5. Die Vorrichtung gemäß Anspruch 4, bei der entweder:

(a) beide Elektroden (14, 16) ein Metall aufweisen, das dasselbe oder unterschiedlich sein kann;
(b) eine der Elektroden (14, 16) ein Metall aufweist und die andere der Elektroden (16, 14) einen Halbleiter aufweist, oder
(c) beide Elektroden (14, 16) einen Halbleiter aufweisen, der derselbe oder unterschiedlich sein kann.

6. Die Vorrichtung gemäß Anspruch 3, wobei die Vorrichtung (20) eine Dreielektrodenvorrichtung ist, die eine Gateelektrode (14'), eine Halbleiterelektrode (16'), die Source(22)- und Drain(24)-Regionen aufweist, die durch eine

Kanalregion (26) getrennt sind, und das zwischen der Gateelektrode (14') und der Halbleiterelektrode (16') angeordnete aktive Material (12) aufweist, wobei die elektrischen Eigenschaften des Kanals (26) in der Lage sind, durch die Ladungsübertragung in dem aktiven Material (12) verändert zu werden.

**7.** Die Vorrichtung gemäß Anspruch 6, bei der entweder:

(a) die Gateelektrode (14') ein Metall aufweist; oder
(b) die Gateelektrode (14') einen Halbleiter aufweist.

**8.** Eine Vorrichtung, die folgende Merkmale aufweist:

zumindest eine erste Vorrichtung (10) gemäß Anspruch 4 oder 5; und zumindest eine zweite Vorrichtung (20) gemäß Anspruch 6 oder 7.

**9.** Die Vorrichtung gemäß Anspruch 8, bei der die zumindest eine erste Vorrichtung (10) und die zumindest eine zweite Vorrichtung (20) entweder:

(a) in Reihe geschaltet; oder
(b) parallel geschaltet

sind.

**Revendications**

**1.** Mince film moléculaire, dans lequel les propriétés électriques des molécules du mince film moléculaire (112; 212) peuvent être changées par un transfert de charge dans le mince film moléculaire (112; 212) induit par un champ électrique et sont retenues lorsque le champ électrique est éliminé, les molécules du mince film moléculaire (112; 212) comprenant:

au moins trois parties (A, B, C), où une partie (A; C) des au moins trois parties (A, B, C) comprend une paire de charges qui est adaptée pour être séparée en différentes parties (A, B) sous l'influence du champ électrique, dans lequel les au moins trois parties (A, B, C) sont des fractions conjuguées avec au moins une liaison $\pi$ dans chaque fraction, une fraction (C) liant les autres fractions (A, B) l'une à l'autre, pour former un mince film moléculaire conjugué complété (112), et la paire de charges séparée provoquant un grand intervalle de bande lorsqu'il n'est pas appliqué de champ électrique, et
dans lequel les chaînes p conjuguées entre deux parties terminales (A, B) sont cassées et une liaison $\sigma$ est formée dans la partie centrale (C) lors de l'application dudit champ électrique, réétablissant ainsi une communication n complète dans les au moins trois parties (A, B, C), et la paire de charges séparée provoquant un petit intervalle de bande.

**2.** Mince film moléculaire selon la revendication 1, dans lequel les au moins trois parties comprennent une pluralité de molécules neutres (A, D), dans lequel l'une des molécules (D) est un donneur d'électrons ayant un faible potentiel d'ionisation, dans lequel une autre des molécules (A) est un accepteur d'électrons ayant une haute affinité pour les électrons, et dans lequel le transfert de charge entre le donneur d'électrons (D) et l'accepteur d'électrons (A) est provoqué sous l'influence dudit champ électrique, formant ainsi une paire de charges radicalaire.

**3.** Dispositif présentant au moins deux électrodes (14, 16; 14', 16') et un matériau actif (12) associé électriquement avec lesdites au moins deux électrodes, ledit matériau actif comprenant ledit mince film moléculaire selon la revendication 1 ou 2.

**4.** Dispositif selon la revendication 3, dans lequel ledit dispositif (10) est un dispositif à deux électrodes, comprenant deux électrodes (14, 16) et ledit matériau actif (12) disposé entre ces dernières et y associé électriquement.

**5.** Dispositif selon la revendication 4, dans lequel soit:

(a) lesdites deux électrodes (14, 16) comprennent un métal qui peut être le même ou différent;
(b) l'une desdites électrodes (14, 16) comprend un métal et l'autre desdites électrodes (16, 14) comprend un

semiconducteur, soit
(c) lesdites deux électrodes (14, 16) comprennent un semiconducteur qui peut être le même ou différent.

**6.** Dispositif selon la revendication 3, dans lequel ledit dispositif (20) est un dispositif à trois électrodes, comprenant une électrode de porte (14'), une électrode semi-conductrice (16') comprenant des régions de source (22) et de drain (24) séparées par une région de canal (26), et ledit matériau actif (12) disposé entre l'électrode de porte (14') et l'électrode semi-conductrice (16'), dans lequel les propriétés électriques dudit canal (26) sont à même d'être changées par ledit transfert de charge dans ledit matériau actif (12).

**7.** Dispositif selon la revendication 6, dans lequel soit:

(a) ladite électrode de porte (14') comprend un métal; soit
(b) ladite électrode de porte (14') comprend un semiconducteur.

**8.** Dispositif, comprenant:

au moins un premier dispositif (10) selon la revendication 4 ou 5; et
au moins un deuxième dispositif (20) selon la revendication 6 ou 7.

**9.** Dispositif selon la revendication 8, dans lequel l'au moins un premier dispositif (10) et l'au moins un deuxième dispositif (20) sont soit:

(a) connectés en série; soit
(b) connectés en parallèle.

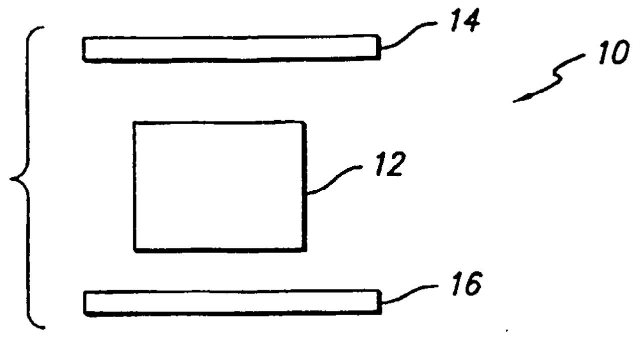


FIG. 1

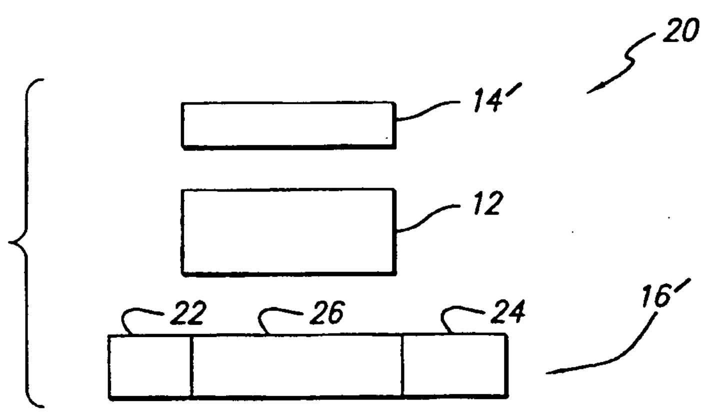


FIG. 2

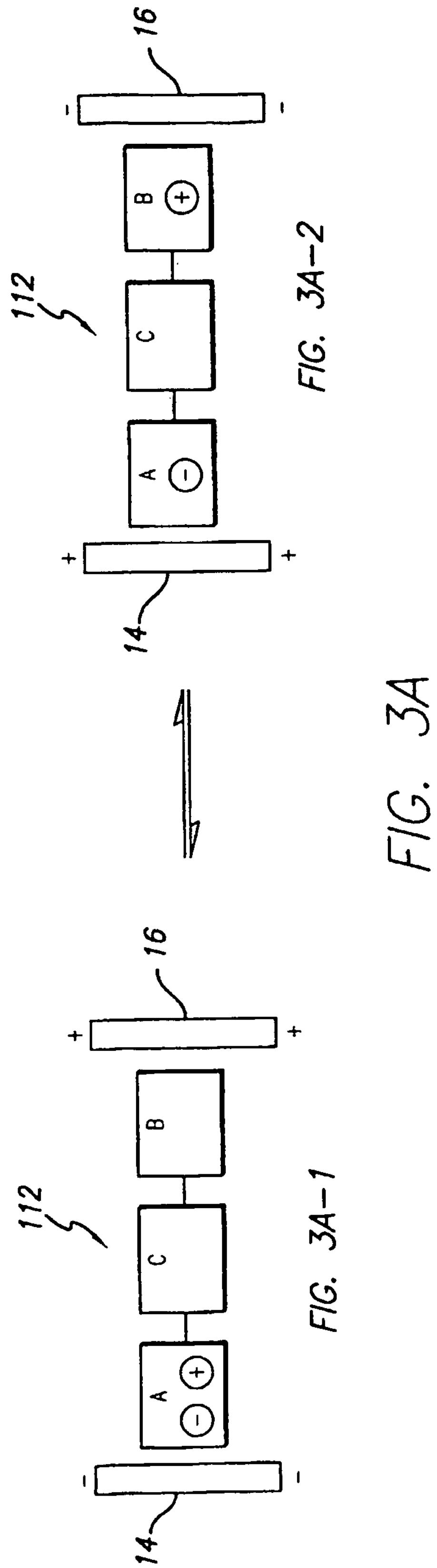


FIG. 3A-2

FIG. 3A-1

FIG. 3A

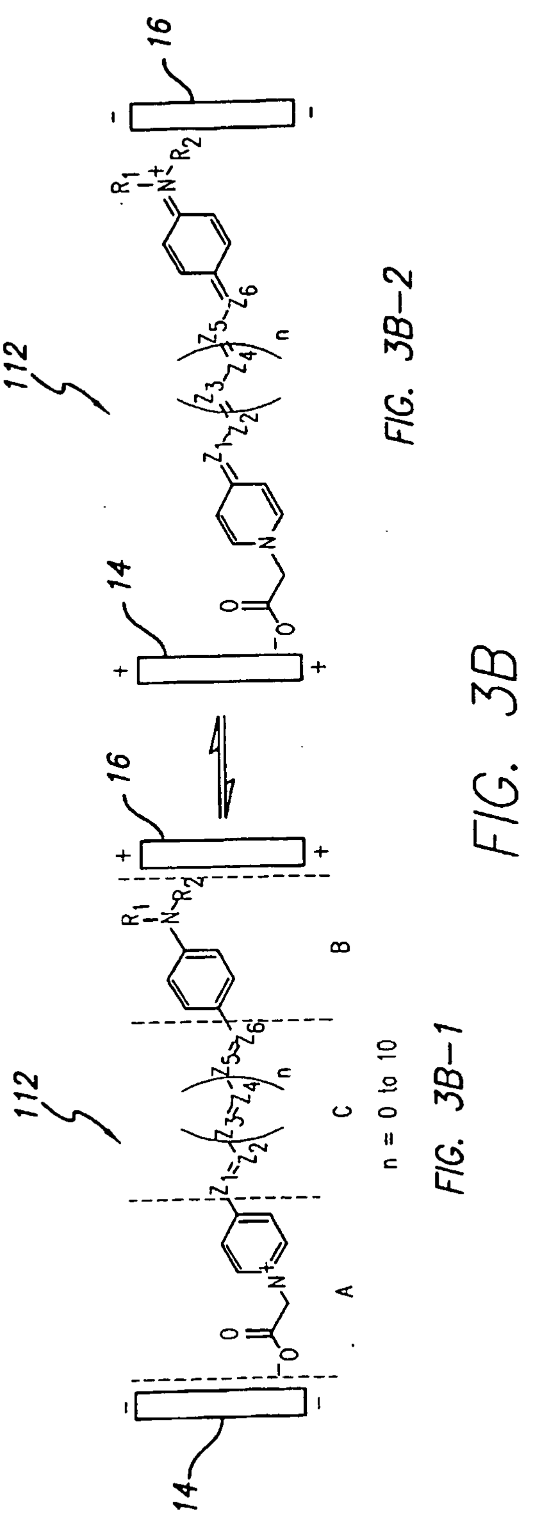

FIG. 3B-1

FIG. 3B-2

FIG. 3B

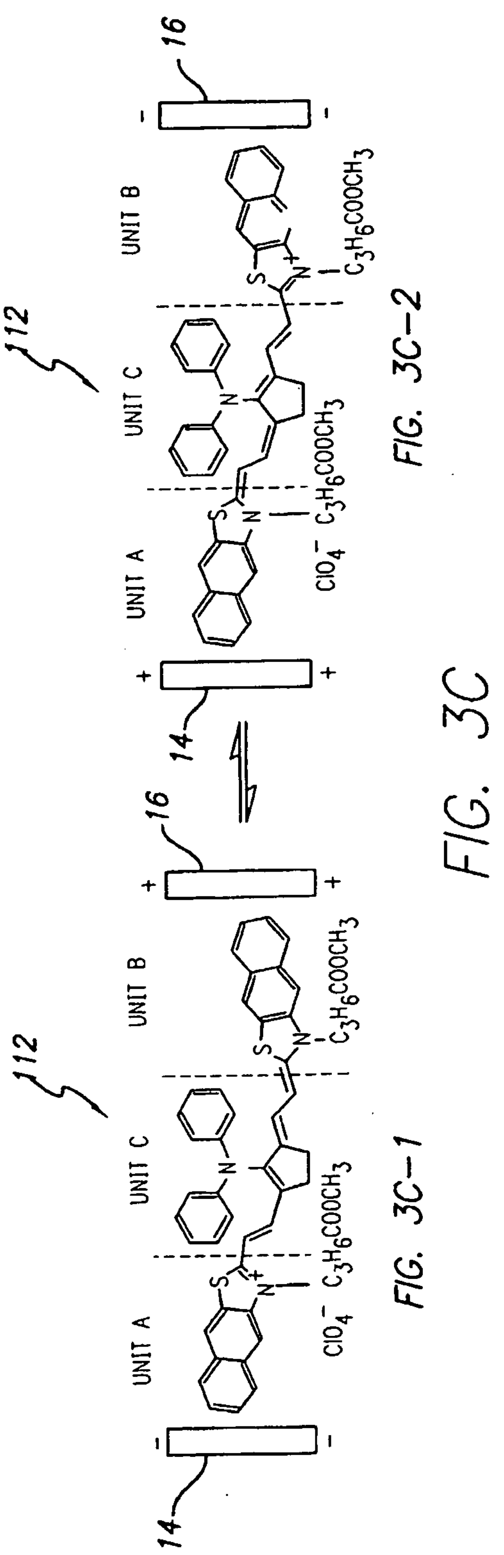

FIG. 3C-1

FIG. 3C-2

FIG. 3C

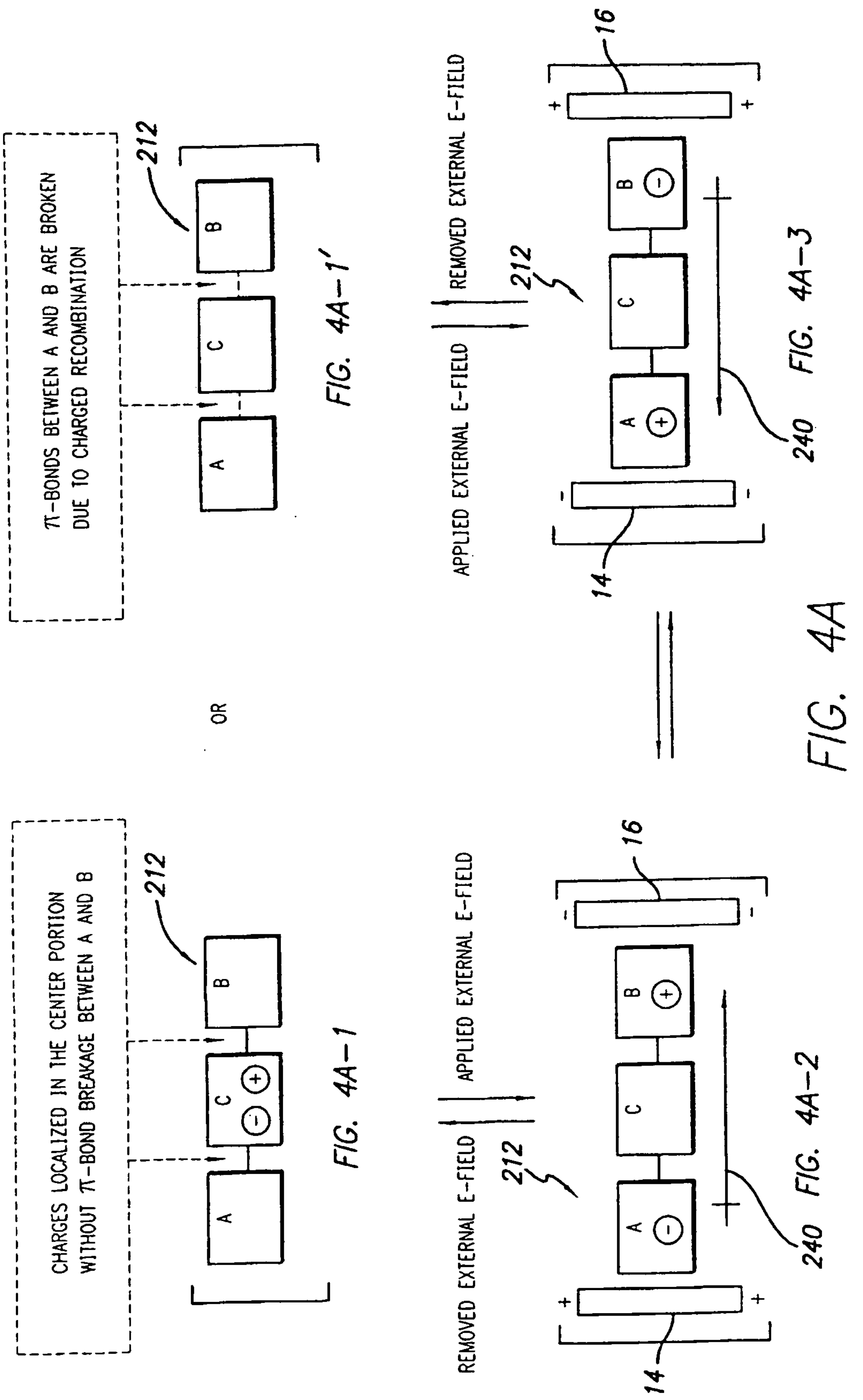


FIG. 4A–1′

FIG. 4A–3

FIG. 4A–1

FIG. 4A–2

FIG. 4A

FIG. 4B-1

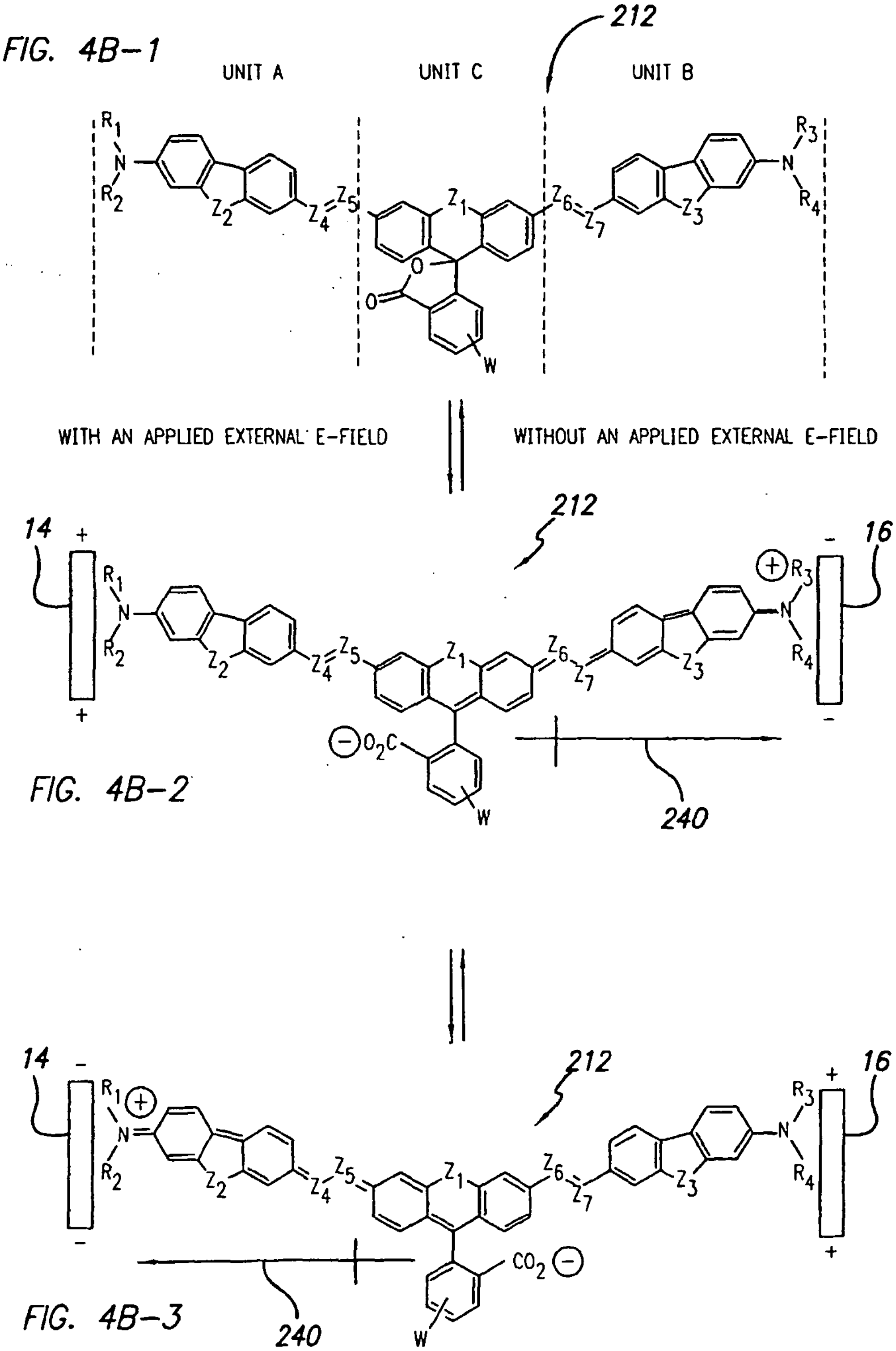


FIG. 4B-2

FIG. 4B-3

FIG. 4B

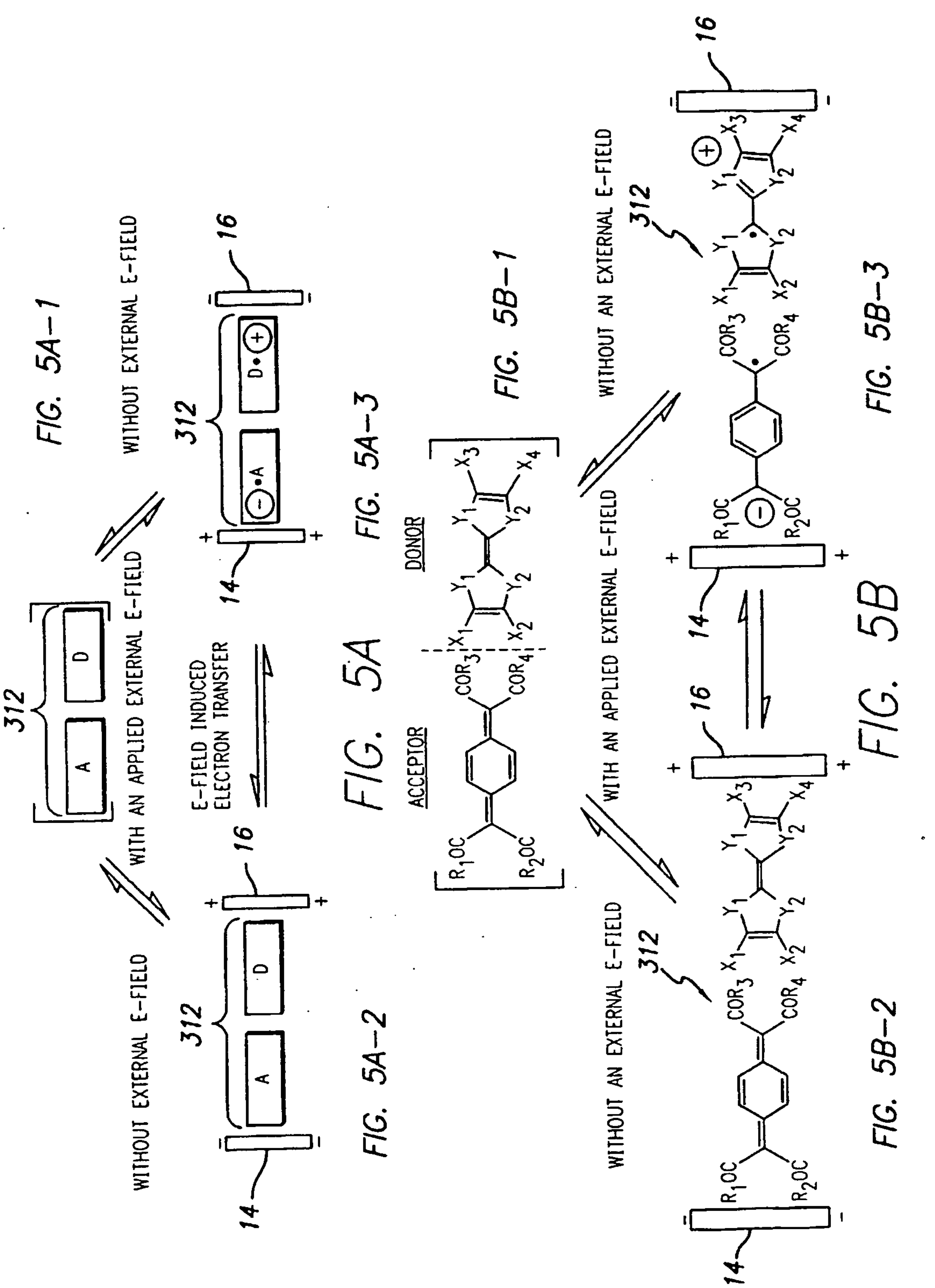


FIG. 5A-1

FIG. 5A-2

FIG. 5A-3

FIG. 5A

FIG. 5B-1

FIG. 5B-2

FIG. 5B-3

FIG. 5B

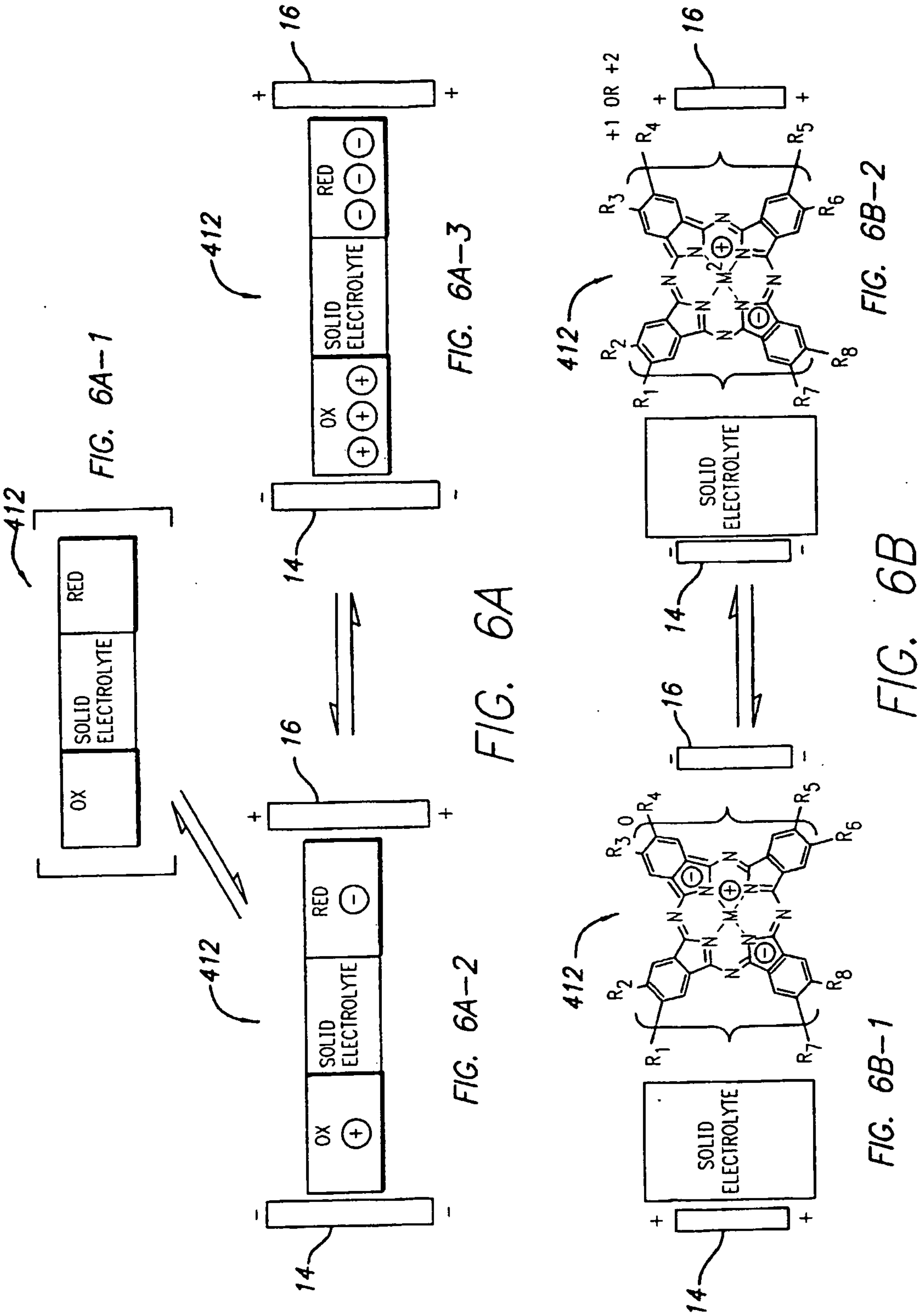


FIG. 6A-1

FIG. 6A-2

FIG. 6A-3

FIG. 6A

FIG. 6B-1

FIG. 6B-2

FIG. 6B

FIG. 7A

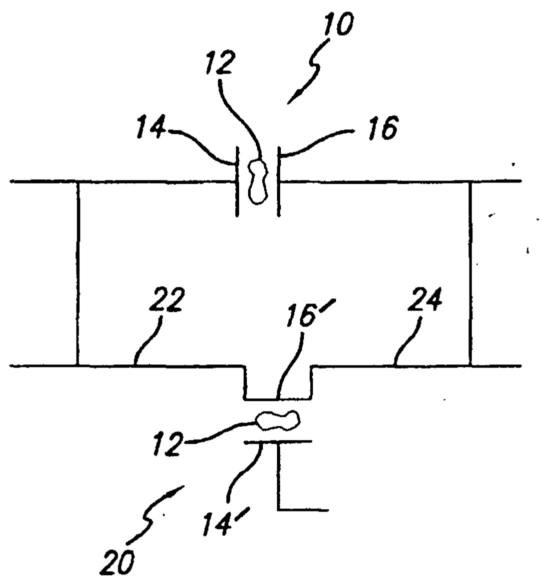


FIG. 7B

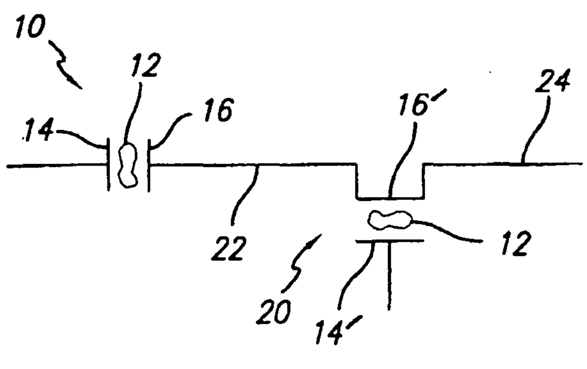

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 02091476 A1
- US 20030111670 A1
- WO 03005116 A1
- WO 02091495 A2
- US 20030169618 A1
- US 6128214 A
- US 20020158244 A1
- US 6256767 B
- US 20060102959 A1

### Non-patent literature cited in the description

- Bistable Molecular Conductors with a Field-Switchable Dipole Group. **KORNILOVITCH P. E. et al.** Physical Review, B. Condensed Matter. American Institute of Physics, 15 December 2002, vol. 66, 245413-1